Europäisches Patentamt

European Patent Office

Office européen des brevets

(19)

(11) Publication number: **0 305 977**
**A2**

# EUROPEAN PATENT APPLICATION

(21) Application number: 88114150.1

(51) Int. Cl.⁴: **H01L 21/385**

(22) Date of filing: 30.08.88

The title of the invention has been amended (Guidelines for Examination in the EPO, A-III, 7.3).

(30) Priority: 04.09.87 JP 221411/87

(43) Date of publication of application:
08.03.89 Bulletin 89/10

(84) Designated Contracting States:
DE FR GB

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Kinugawa,Masaaki c/o Patent**
**Division**
**Kabushiki Kaisha Toshiba 1-1 Shibaura**
**1-chome**
**Minato-ku Tokyo 105(JP)**

(74) Representative: **Henkel, Feiler, Hänzel &**
**Partner**
**Möhlstrasse 37**
**D-8000 München 80(DE)**

(54) **Method for doping a semiconductor integrated circuit.**

(57) A semiconductor device of the present invention is manufactured by subjecting a semiconductor structure to an annealing process to allow an impurity to be diffused from a boron-bearing metal thin film. It is thus possible to shallowly and uniformly form a diffusion layer whose impurity concentration level is made high and uniform.

F I G. 2C

EP 0 305 977 A2

## Method for manufacturing a semiconductor intergrated circuit

The present invention relates to a method for manufacturing a semiconductor integrated circuit having MOS type elements.

In the formation of the source and drain areas of MOSFETs (insulated-gate type field effect transistors) of a semiconductor integrated circuit, the conventional method includes, subsequent to implanting an impurity ion in the source and drain formation areas on the surface portion of a semiconductor substrate, performing an annealing step at about 900°C for defect recovery at the ion implantation and for ion activation. In this case, the source and drain areas of an N-channel MOS transistor are formed using arsenic with a greater mass and smaller thermal diffusion coefficient, and the junction depth of the source and drain areas is about 0.2 $\mu$m. On the other hand, the source and drain areas of a P-channel MOS transistor are formed using boron with a smaller mass, greater penetration depth at the ion implantation time and greater thermal coefficient, and the junction depth of the source and drain areas is about 0.4 $\mu$m or more, a value much greater than that of the N-channel MOS transistor.

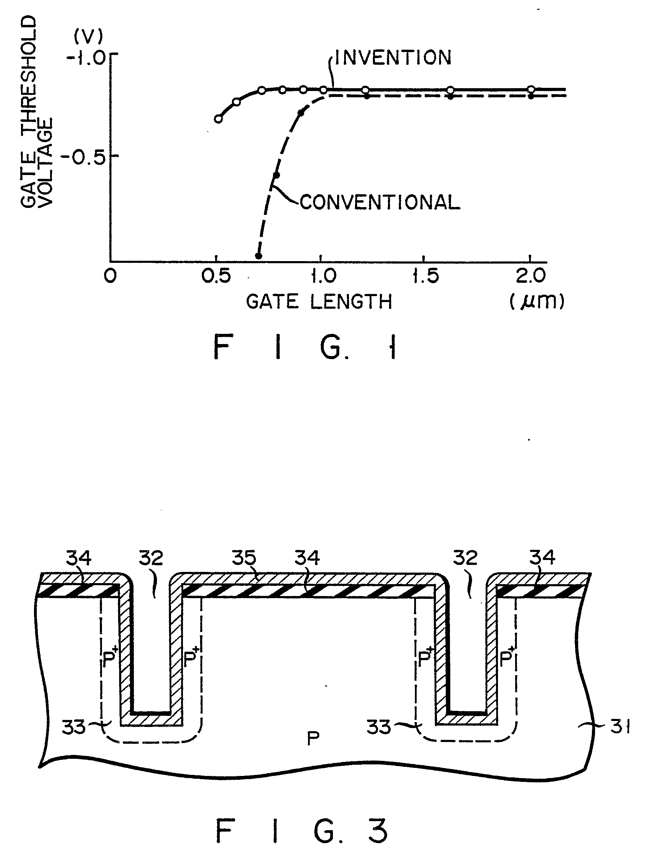

If, as set out above, the source and drain junction depths of the P-channel MOS transistor are greater, then a so-called "short channel effect" becomes prominent, that is, the fall of the gate threshold voltage when the gate length of the P-channel MOS transistor is short becomes prominent as indicated by a broken line in Fig. 1.

With a further advance in the microminiaturization of N-channel MOS transistors, there is a risk that such a short channel effect will become prominent at the N-channel MOS transistor. Furthermore, where an impurity for P-channel for example is diffused in the inner surface of a groove, such as a trench capacitor of a dynamic RAM, a problem is created, that is, in the ion implantation step, that impurity level becomes markedly smaller at the side wall of the groove than at the bottom of the groove. In the conventional solid-phase diffusion method using BSG (borosilicate glass) etc., as a diffusion source, it has been difficult to diffuse the diffusion material at a high concentration level.

The present invention has been achieved so as to solve the difficulty encountered in forming a shallower impurity diffusion layer by a conventional ion implantation method in the surface of a semiconductor substrate, in forming an impurity diffusion layer of uniform depth in the inner surface of trenches in the substrate surface portion and in achieving a high concentration diffusion by a conventional solid-phase diffusion method.

It is accordingly the object of the present invention to provide a method for manufacturing a semiconductor integrated circuit, which can shallowly and uniformly diffuse an impurity in the surface portion of a semiconductor substrate at a high concentration level, even when trenches or grooves are formed in the surface portion of the semiconductor substrate, and can form source and drain regions of a MOS transistor with a shallow junction depth and thus can suppress a short channel effect.

A method for the manufacture of a semiconductor integrated circuit of the present invention comprises covering the whole surface of a semiconductor substrate structure with an insulating film of such a material that an impurity is hard to be diffused therein, removing a portion of the insulating film, forming a thin metal film, serving as an impurity diffusion source, over the whole surface of the semiconductor substrate, and subjecting a resultant structure to an annealing process.

Where, for example, a boron-bearing metal thin film is employed as a metal thin film, a P-type impurity can uniformly and very shallowly be diffused in a substrate surface portion not covered with an insulating film, even if grooves such as trench capacitors and element area isolation grooves are formed in the surface portion of the semiconductor substrate. If, therefore, source and drain regions of a P-channel MOS transistor is to be formed with an N-channel element area covered with an insulating thin film, the source and drain regions of shallow junction depth can be formed, without exerting any influence over the characteristic of the N-channel MOS transistors, and it is thus possible to obtain P-channel transistors whose source and drain junction depths are made shallower, and hence to suppress the short channel effect. Furthermore, where a metal thin film is formed on the inner surface of a trench in a respective trench capacitor, it is possible to uniformly form a trench-to-trench leakage current prevention layer on the inner surface of the trench. If an impurity is diffused with the metal thin film formed on the inner surface of the element area isolation trench, a high concentration layer for preventing formation of a parasitic channel can uniformly be formed in the inner surface of the trench.

This invention can be more fully understood from the following detailed description when taken in conjunction with the accompanying drawings, in which:

Fig. 1 is a graph showing a relation between the gate length and the gate threshold voltage of a MOS transistor:

Figs. 2A to 2D show a process for manufacturing a semiconductor device according to an embodiment of the present invention; and

Fig. 3 shows a process for manufacturing a trench capacitor in a semiconductor device according to another embodiment of the present invention.

The embodiment of the present invention will be explained below with reference to the accompanying drawings.

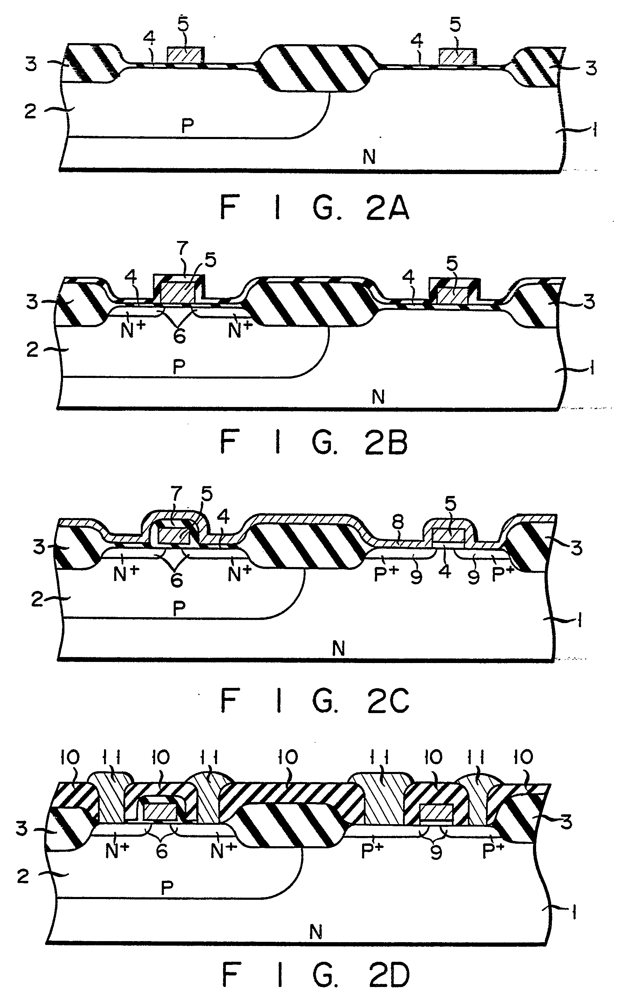

Figs. 2A to 2D show the major steps of manufacturing a CMOS transistor of a CMOS integrated circuit. That is, as shown in Fig. 2A, P-well 2 is formed in the surface portion of N-type semiconductor substrate 1 as in the prior art and thermal oxidation film 3 for element isolation is formed by a selective oxidation method on the surface of the resultant structure. Then gate oxidation film 4 is formed on the surface of the structure and a poly-Si layer is deposited by an LPCVD (low pressure chemical vapor deposition) on the surface of the structure. Subsequent to forming a photoresist film on the poly-Si layer, the photoresist film is patterned by a lithography method and gate electrode 5 is formed by an RIE (reactive ion etching) method. Then arsenic ions are implanted only at an N-channel MOS transistor formation area and annealing step is performed, causing the implanted ions to be activated to provide $N^+$ layers for source and drain areas 6 of N-channel transistor as shown in Fig. 2B. The resultant structure is oxidized in an oxygen atmosphere at 900° C to provide thermal oxidation film 7 on the whole surface of the structure. In this case, about 150 Å-thick thermal oxidation film is formed on the surface of the structure in which case about 400 Å-thick film is formed over gate electrode 5 due to a difference in an oxidation rate (Fig. 2B). Then the N-channel MOS transistor area is covered with a resist and oxidation film 7 is removed off the P-channel transistor formation area by the use of ammonium fluoride ($NH_4F$), followed by the removal of the resist. Then about 50 Å-thick boron-bearing thin metal film 8 is formed by a vacuum evaporation method on the surface of the resultant structure and annealing step is conducted in a vacuum atmosphere at 850° C for 30 minutes to provide $P^+$ layers for source and drain regions 9. Then remaining boron-bearing metal thin film 8 is exposed to a nitrogen gas atmosphere at 700° C for 30 minutes which contains a very small amount of vapor. By so doing, the boron-bearing metal thin film is converted to borosilicate glass (Fig. 2C). $SiO_2$ film 10 is deposited by the CVD method on the whole surface of the structure and contact holes are formed for the corresponding transistor regions. An aluminum film is deposited on the surface of the resultant structure and a patterning is performed on the surface of the structure to provide connection 11 (Fig. 2D).

According to the aforementioned embodiment, the N-channel MOS transistor areas are covered with insulating thin film 7 and impurity diffusion is made with boron-bearing thin film 8 as an impurity diffusion source to provide source and drain regions for the P-channel transistor with a very shallow $P^+$ junction. As a result, the P-channel transistor is such that, as indicated by a solid line in Fig. 1, a decline in the gate threshold voltage can be suppressed to a small extent despite the fact that the gate length is short, and that the short channel effect can be prominently suppressed in comparison with the conventional characteristic indicated by the broken line in Fig. 1.

As set forth above, during the formation of source and drain regions 9 for the P-channel MOS transistor the N-channel MOS transistor areas are covered with the thermal oxidation film and, with the boron-bearing metal thin layer as an impurity diffusion source, that impurity is diffused into the source and drain formation regions. The boron is not diffused in the N-channel MOS transistor areas. Thus the characteristic of the N-channel MOS transistor is not affected by boron diffusion so that it is possible to obtain an excellent characteristic as in the prior art.

Although thermal oxidation film 7 has been explained as being an $SiO_2$ film, it is not restricted to the $SiO_2$ film and use may be made of any other proper insulating thin film of such a material that an impurity is hard to be diffused therein. For example, the silicon nitride film may be used either singly or in a super-imposed fashion to the $SiO_2$ film.

The evaporation of boron thin film 8 which serves as an impurity source as in the aforementioned embodiment can be achieved by the following techniques: (1) it becomes possible to form a high purity boron target and (2) a high vacuum technique can be implemented which is necessary to conduct a vacuum evaporation with the boron, as a target. which is readily liable to react with oxygen.

Fig. 3 shows another embodiment of the present invention in which, when a trench capacitor is to be formed in a dynamic RAM integrated circuit, $P^+$ layer 33 for preventing a trench-to-trench leakage current is formed in the inner surface of trench 32 which is formed in the surface portion of $P^+$ layer (or P-well). The substrate surface other than the inner surface of trench 32 is covered with thermal oxidation film 34 so as to prevent diffusion of an impurity into the surface portion of substrate 31. Boron-bearing metal thin film 35 is formed on the surface of the resultant structure, including the inner surface of trench 32, and the resultant structure is annealed in the high-temperature, vacuum atmosphere for a given time. As a result, the boron is diffused from the boron-bearing metal thin film 35 into the inner surface portion of trench 32 and activated, so that P$^+$ layer 33 is uniformly formed, as a high impurity layer, in the inner surface portion of trench 32. As thermal oxidation film 34 for preventing boron from being diffused from boron-bearing metal thin layer 35 into the surface portion of substrate 31, use may be made of one formed prior to the formation of the trench. This concept can be applied to the case where, during the formation of trenches for isolation of MOS transistors in a semiconductor integrated circuit according to another embodiment of the present invention, a P$^-$ layer for preventing a trench-to-trench leakage current is formed in the inner surface of the trenches which are formed in the surface portion of a P-type substrate. In this case, the substrate surface except for the surface of the trench is covered with a thermal oxidation film and a boron-bearing metal thin film is formed on the substrate surface portion including the inner surface of the trench. The resultant structure is annealed, for a given period of time, in a high-temperature, vacuum atmosphere, causing the boron to be diffused from the boron-bearing metal thin film into the inner surface portion of the trench and the boron ions to be activated so that the P$^-$ layer is formed uniformly on the inner surface of the trench.

Although in the aforementioned respective embodiment the boron-bearing metal thin film has been explained as being used for P-type impurity diffusion, if an N-type impurity diffusion is to be performed, a P-channel element area is covered with an insulating thin film and a metal thin film, serving as an impurity diffusion source, is formed on the whole surface of the substrate, followed by an annealing step for an impurity ion to be activated.

The Effects of the Present Invention

In the semiconductor integrated circuit of the present invention, as set out above, even if trenches are formed in the surface portion of the semiconductor substrate, an impurity can be shallowly and uniformly diffused as a high impurity layer in the surface portion of the substrate. Where, therefore, the source and drain areas of the MOS transistor are formed in the surface portion of the substrate, their junction depth becomes shallow and the short channel effect can be suppressed. Where an impurity diffusion layer is formed in the inner surface portion of the trenches in the trench capacitor, it can be formed, as a uniform layer, in the side wall and bottom of the trench.

Claims

1. A method for manufacturing a semiconductor device comprising the steps of:
forming an insulating film (7) over a whole surface of a semiconductor substrate (1), said insulating film being such that an impurity is hard to be diffused therein;
removing a portion of the insulating film (7);
forming a metal thin film (8, 35) for impurity diffusion on the surface of the semiconductor substrate (1) and insulating film (7); and
subjecting a resultant structure to an annealing step.

2. The method according to claim 1, characterized in that said step of forming an insulating film (7) is a step performed subsequent to forming a gate electrode of a MOS transistor.

3. The method according to claim 1, characterized in that said step of forming an insulating film (7) comprises a step of exposing a semiconductor substrate portions corresponding to source and drain formation areas of a MOS transistor formed subsequent to forming a gate electrode of the transistor.

4. The method according to claim 1, characterized in that said step of forming a metal thin layer (8, 35) comprises a step of forming a metal thin film by a vacuum evaporation method.

5. The method according to claim 1, characterized in that said step of forming a metal thin film (8, 35) comprises a step of forming a metal thin film by a vacuum evaporation method on said insulating film (7) which is formed over an inner surface of trenches in said semiconductor substrate and on a remaining surface of a resultant structure.

6. The method according to claim 1, characterized in that said step of subjecting a resultant structure to an annealing step comprises a step of diffusing an impurity into said semiconductor substrate portion corresponding to source and drain formation areas of a MOS transistor.

7. The method according to claim 1, characterized in that said insulating film (7) is a silicon oxide film.

8. The method according to claim 1, characterized in that said insulating film (7) is a silicon nitride film.

9. The method according to claim 1, characterized in that said metal thin film (8, 35) is a boron-bearing metal thin film.

F I G. 1

F I G. 3

F I G. 2A

F I G. 2B

F I G. 2C

F I G. 2D